# EUROPÄISCHE PATENTSCHRIFT

(11) **EP 0 507 168 B1**
(45) Veröffentlichungstag und Bekanntmachung des Hinweises auf die Patenterteilung: **15.01.1997**
(21) Anmeldenummer: 92104967.2
(22) Anmeldetag: 23.03.1992
(51) Int. Cl.: G01R 31/28

(54) **Verfahren zum Testen von auf Platinen eingelöteten integrierten Halbleiterschaltkreisen und Verwendung eines Transistortesters für dieses Verfahren**
Method for testing of integrated semiconductor circuits soldered in circuit boards and usage of a transistor tester for this method
Méthode pour tester des circuits integrés semi-conducteurs soudés sur platines, et utilisation d'un testeur de transistor pour cette méthode

(30) Priorität: 30.03.1991 DE 4110551
(43) Veröffentlichungstag der Anmeldung: 07.10.1992
(73) Patentinhaber: ITA INGENIEURBÜRO FÜR TESTAUFGABEN GmbH, D-22769 Hamburg (DE)
(72) Erfinder: Buks, Manfred, W-2359 Henstedt-Ulzburg 3 (DE)
(74) Vertreter: Schaefer, Konrad, Dipl.-Phys.

(56) Entgegenhaltungen:
- GB-A- 1 558 502
- US-A- 4 035 826

## Beschreibung

Die Erfindung betrifft ein Verfahren nach dem Oberbegriff des Anspruches 1 sowie die Verwendung eines Transistortesters für dieses Verfahren.

Bei der Herstellung elektronischer Schaltungen werden Platinen mit ICs (integrierte Halbleiterschaltkreise) bestückt. Wichtig ist dabei, daß die ICs mit ihren Anschlußpins ordnungsgemäß verlötet werden. Dabei können Fehler auftreten, so daß einzelne Pins von ICs nicht ordnungsgemäß kontaktiert sind.

Nach der Bestückung müssen die Platinen auf ordnungsgemäße Funktion getestet werden. Nach dem Stand der Technik gibt es dabei zwei Möglichkeiten. Zum einen kann ein vollständiger Funktionstest durchgeführt werden. Sämtliche Ein- und Ausgänge der Platine werden mit einem Testcomputer verbunden, und es werden alle Funktionen der Schaltung durchgetestet. Bei komplexen Schaltungen, wie sie heutzutage üblich sind, dauert ein solcher Funktionstest aber sehr lange. Außerdem können größere Schaltungen aus verschiedenen Gründen kaum noch einem vollständigen Funktionstest unterworfen werden.

Besser ist es daher, die ICs vor dem Einlöten zu testen und anschließend nach Bestückung der Platine nur noch die ordnungsgemäße Kontaktierung der Pins der ICs zu überprüfen.

Es sind Verfahren nach dem Oberbegriff des Anspruches 1 bekannt, bei denen an auf Platinen eingelöteten ICs die Kontaktierung geprüft wird, in dem jeweils zwischen zwei Pins eines ICs die dazwischenliegende Diode im IC geprüft wird. Mit einer einfachen Messung kann die Diodenkennlinie ermittelt werden, und man hat dadurch eine sichere Aussage darüber, daß diese Diode noch ordnungsgemäß funktioniert und vor allem, daß die beiden fraglichen Pins ordnungsgemäß verlötet sind.

Sind an zwei Leiterbahnen einer Platine, die zu diesem Zweck mit einem Testgerät kontaktiert werden, nur diese beiden Pins eines IC angeschlossen, so ergibt sich ein eindeutiges Meßergebnis. Probleme ergeben sich dann, wenn mehrere Dioden eines oder mehrer ICs parallel an den beiden vom Testgerät kontaktierten Leiterbahnen angeschlossen sind. Dann ist es schwierig, festzustellen, ob Strom durch alle parallelen Dioden fließt oder ob beispielsweise eine von diesen durch fehlerhafte Kontaktierung stromlos bleibt. Dies ergibt sich aus der Tatsache, daß die Kennlinien der Dioden große Herstellungstoleranzen haben und daß auf ICs ohnehin Dioden konstruktionsbedingt stark unterschiedliche Kennlinien haben können. An dem gemessenen Strom ist bei mehreren parallelen Dioden nicht eindeutig ablesbar, ob alle Dioden korrekt angeschlossen sind oder ob eine z.B. durch einen Kontaktfehler ausfällt. Daraus ergeben sich enge Grenzen für die Anwendbarkeit dieser als Knotenimpedanzmessung bekannten Methode.

Die Aufgabe der vorliegenden Erfindung besteht daher darin, ein Verfahren der eingangs genannten Art zu schaffen, mit dem auch bei komplizierterer Vernetzung die einzelnen ICs eindeutig testbar sind.

Diese Aufgabe wird erfindungsgemäß mit einem Verfahren mit den im Anspruch 1 angegebenen Verfahrensschritten gelöst.

Die Erfindung macht sich die Tatsache zunutze, daß zwischen den Pins von ICs nicht nur Dioden vorliegen, sondern auch Transistoren. Es handelt sich dabei aber nicht um die aus dem Schaltbild des IC zu ersehenden Transistoren, die wegen der inneren Beschaltung über Pins des IC nicht ansteuerbar sind, sondern um sogenannte parasitäre Transistoren. Diese sind aus der Literatur an sich bekannt, allerdings nur wegen ihrer störenden Eigenschaften. Parasitäre Transistoren ergeben sich in einem IC immer dann, wenn von einem als Basis anzuschließenden Pin Dioden zu zwei anderen Pins verlaufen. Die parasitären Transistoren können sehr eigenartige Transistorkennlinien aufweisen. Es lassen sich aber immer die typischen Steuer- oder Schaltmerkmale eines Transistors bestimmen, die die ordnungsgemäße Funktion des Transistors anzeigen. Der Vorteil gegenüber der bekannten Knotenimpedanzmethode besteht darin, daß aufgrund der Beschaltung von drei Pins eines Transistors an einem IC die Möglichkeit so gut wie ausgeschlossen ist, daß bei einer Testmessung zwei verschiedene parasitäre Transistoren parallel liegen. Es werden also mit jeder Messung immer nur drei Pins eines IC separat für sich gemessen, ohne daß parallele Schaltungsteile der Platine die Messung wesentlich beeinflussen. Dadurch lassen sich mit hoher Sicherheit Aussagen über die ordnungsgemäße Funktion der ICs treffen.

Das erfindungsgemäße Verfahren kann auch ohne nähere Kenntnis des vorliegenden ICs angewendet werden, indem probeweise Kombinationen von je drei Pins des ICs vermessen werden, solange bis geeignete parasitäre Transistoren gefunden werden, die am Vorliegen einer charakteristischen Transistorkennlinie erkannt werden. Vorzuziehen ist jedoch das Verfahren nach Anspruch 2, wobei ein später auf der Platine zu testender IC zunächst im ausgebauten Zustand vermessen wird unter Bestimmung eines Diodenersatzschaltbildes, das alle jeweils zwischen zwei Pins vorhandenen Dioden angibt. Daraus können vorliegende parasitäre Transistoren erkannt werden, und diese können beim Testen des eingebauten ICs gezielt getestet werden.

Für das erfindungsgemäße Verfahren wird vorteilhaft ein Transistortester nach Anspruch 3 verwendet.

In den Zeichnungen ist die Erfindung beispielsweise und schematisch dargestellt. Es zeigen:
- Fig. 1: zwei auf einer Platine verschaltete, zu testende Inverter,
- Fig. 2: das Schaltbild eines der Inverter der Fig. 1,
- Fig. 3: eine Schaltung zur Bestimmung des Diodenersatzschaltbildes eines der Inverter der Fig. 1,
- Fig. 4: das Diodenersatzschaltbild eines der Inverter der Fig. 1,
- Fig. 5: das Diodenersatzschaltbild der beiden gemäß Fig. 1 verschalteten Inverter und
- Fig. 6: das Kennlinienfeld eines Transistors.

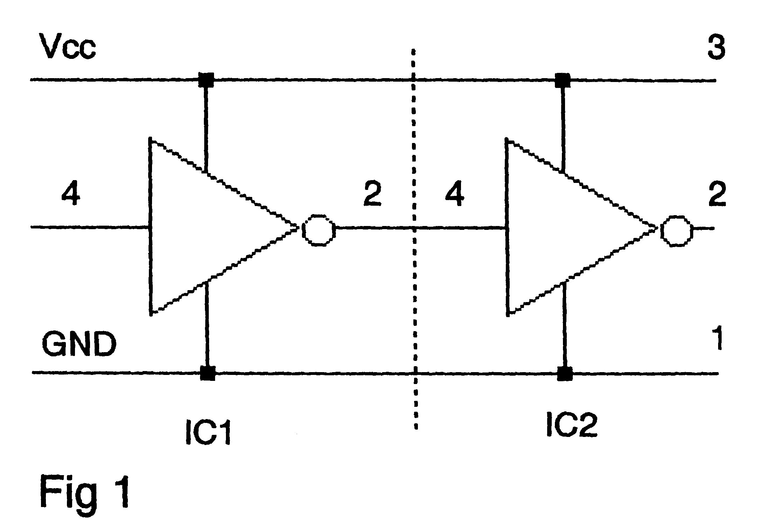

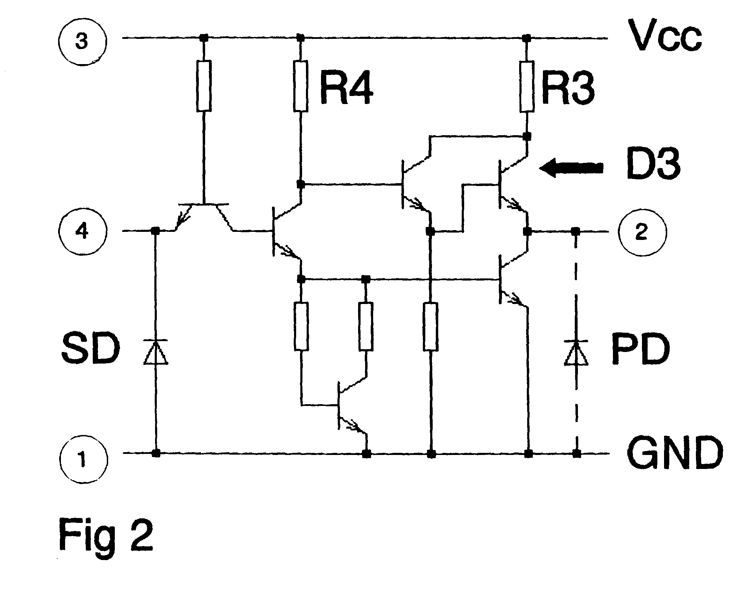

Eine typische Testaufgabe wird anhand der Fig. 1 erläutert. Auf einer Platine sind zwei integrierte Halbleiterschaltungen IC1 und IC2 eingelötet, wobei der Ausgang 2 von IC1 mit dem Eingang 4 von IC2 direkt verbunden ist. Bei den beiden ICs handelt es sich um Inverter, deren Schaltbild die Fig. 2 zeigt. Die auf der Platine anzuschließenden Pins sind mit Zahlen gekennzeichnet wie folgt:
1 Masse (GND)
3 Versorgungsspannung (VCC)
4 Eingang
2 Ausgang

Wie das Schaltbild der Fig. 2 zeigt, besitzt jeder der beiden Inverter IC1 und IC2 am Eingang 4 gegenüber Masse 1 eine Schutzdiode SD und zwischen Ausgang 2 und Masse 1 eine mit gestrichelten Linien dargestellte parasitäre Diode PD. Die parasitäre Diode PD ist üblicherweise in Handbüchern nicht eingezeichnet, in aller Regel bei ICs aber vorhanden. Sie bildet sich zwischen der Leitung 2 und Masse auf dem Substrat der integrierten Schaltung.

Wird die Schaltung der Fig. 1 nun mit der bekannten Knotenimpedanzmethode getestet, so müßte die Verbindungsleitung, die den Ausgang 2 des IC1 mit dem Eingang 4 des IC2 verbindet, auf der Platine kontaktiert werden, und es müßte die Masseleitung 1 kontaktiert werden. Zwischen beiden Leitungen würde nun die Diodenkennlinie bestimmt. Wie Fig. 2 zeigt, würde man bei dieser Messung aber zwei parallele Dioden bestimmen, wobei die parasitäre Diode PD am Ausgang von IC1 parallel zur Schutzdiode SD am Eingang von IC2 liegt. Da die Dioden SD und PD sehr unterschiedliche Kennlinien haben können, könnte es z.B. vorkommen, daß der Unterschied zwischen dem Strom, der bei einer bestimmten Spannung durch eine der beiden Dioden fließt, und dem Strom, der durch die beiden parallelen Dioden fließt, geringer ist als die Stromvarianz aufgrund von Herstellungstoleranzen. Es läßt sich dann nicht mehr mit Sicherheit feststellen, ob beide Dioden ordnungsgemäß angeschlossen sind oder ob eine der beiden Dioden aufgrund eines Fehlers im IC oder bei seiner Verlötung nicht angeschlossen ist.

Zur Lösung dieses Problemes geht die Erfindung wie folgt vor:

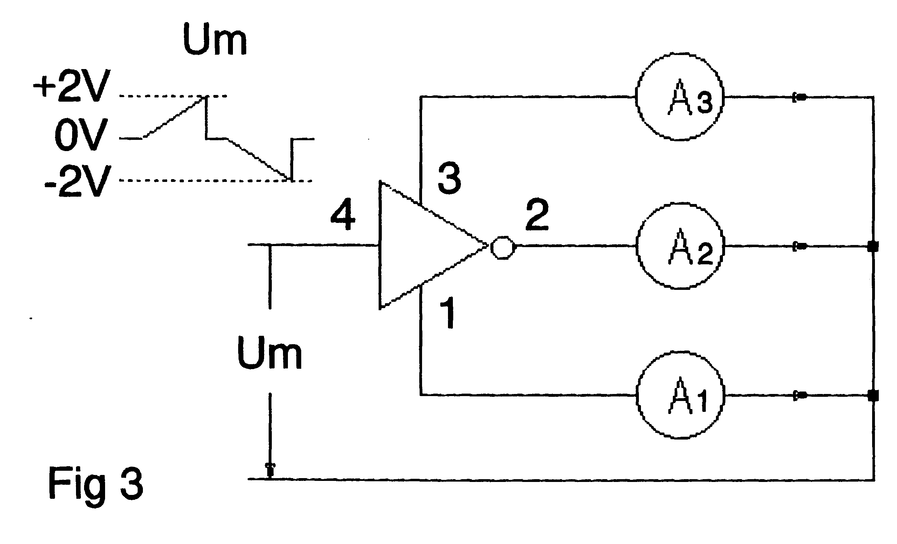

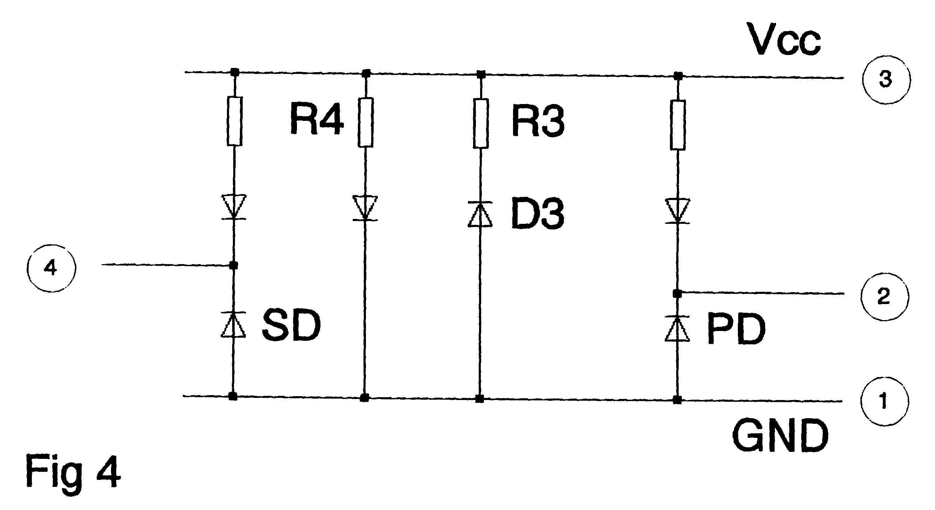

Fig. 3 zeigt einen der in Fig. 1 dargestellten Inverter in einer Meßschaltung, mit der an Pin 4 eine variable Spannung mit unterschiedlichen Vorzeichen, und zwar, wie in der Figur abgebildet, mit Spannungsverläufen zwischen -2 V und +2 V angelegt wird, und zwar gegen die drei anderen parallelgeschalteten Pins 1, 2 und 3, bei denen jeweils einzeln der fließende Strom gemessen wird. Mit einer solchen Meßschaltung gemäß Fig. 3 läßt sich das Diodenersatzschaltbild des Inverters ermitteln, das in Fig. 4 dargestellt ist. Dieses Diodenersatzschaltbild zeigt an, zwischen welchen Pins des IC durch vorhandene Dioden Ströme fließen können.

Wenn, was in der Regel der Fall ist, zwei gleichsinnig gepolte Dioden auf demselben Substrat liegen, so bilden diese Dioden zusammen einen parasitären Transistor. Das ist im Beispiel der Fig. 4 beispielsweise der Fall mit den beiden Dioden SD und PD. Die Pins 2 und 4 können jeweils als Emitter oder Kollektor verwendet werden, wobei die Polung gleichgültig ist. Pin 1 bildet die Basis des parasitären Transistors. Ein weiterer parasitärer Transistor ließe sich bilden aus den Dioden SD und D3, wobei dann die Widerstände R3 und R4 in Reihe liegen. Vergleicht man mit Fig. 2, so sieht man, daß D3 die Kollektordiode eines Transistors ist. Bei diesem parasitären Transistor wäre wiederum Pin 1 die Basis, Pins 3 und 4 können als Emitter oder Kollektor verwendet werden.

Parasitäre Transistoren können vorteilhaft aus dem mit der Meßschaltung der Fig. 3 gewonnenen Diodenersatzschaltbild bestimmt werden, das in Fig. 4 dargestellt ist. Es kann aber auch der zu testende IC an allen Kombinationen seiner Pins mit einem Transistortester kontaktiert werden so lange, bis alle existierenden parasitären Transistoren gefunden sind. Dabei müssen nicht unbedingt alle möglichen Transistoren bestimmt werden, sondern es reicht häufig aus, nur diejenigen Transistoren zu bestimmen, die benötigt werden, um die ordnungsgemäße Kontaktierung bestimmter Pins prüfen zu können.

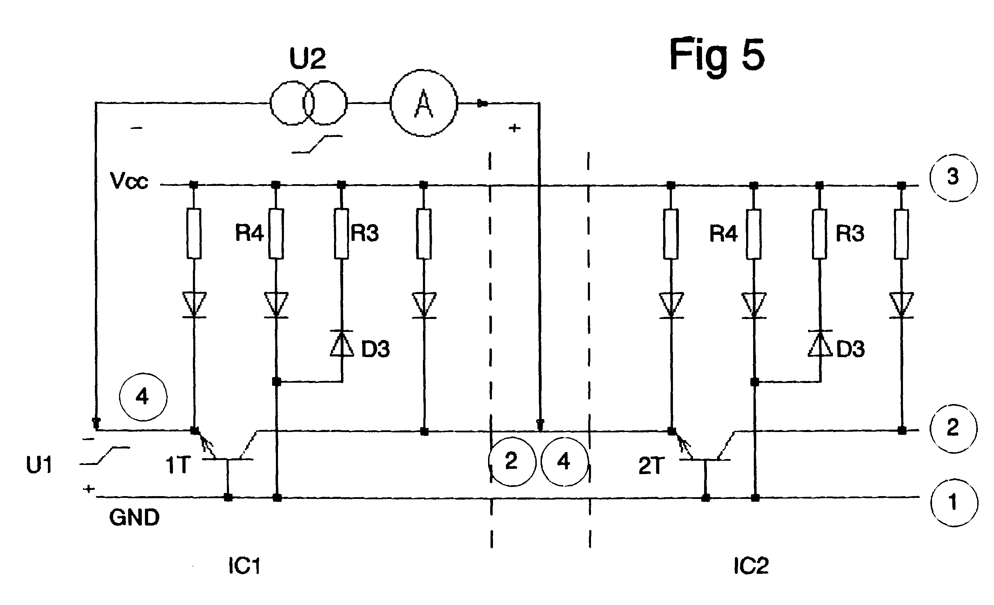

Fig. 5 zeigt die Schaltung der Fig. 1 unter Verwendung des Diodenersatzschaltbildes der Fig. 4 für die beiden Inverter IC1 und IC2. Der parasitäre Transistor, gebildet aus den Dioden SD und PD, ist in beiden Fällen in der üblichen Transistordarstellungsweise eingezeichnet. Der parasitäre Transistor des IC1 ist mit 1T bezeichnet, der des IC2 mit 2T.

Erfindungsgemäß werden zum Testen der Schaltungen IC1 und IC2 deren parasitäre Transistoren 1T und 2T getestet.

Zunächst soll IC1 getestet werden. Dazu wird, wie Fig. 5 zeigt, ein Transistortester kontaktiert, und zwar mit den Pins 1, 4 und 2 des IC1. Zwischen 1 und 4 wird eine variable Basisspannung U1 angelegt. Zwischen 2 und 4 wird eine Kollektor-Emitterspannung U2 angelegt. Der Kollektor-Emitterstrom wird mit dem Meßgerät A bestimmt.

Betrachtet man die beiden miteinander verschalteten Diodenersatzschaltbilder der integrierten Schaltungen IC1 und IC2, so erkennt man, daß parallel zu dem zu bestimmenden Transistor 1T nur die Basis-Emitterstrecke des Transistors 2T des IC2 liegt. Bei dieser liegt aber ersichtlich die Spannung mit falschem Vorzeichen an. Außerdem ist der Kollektor offen. Es kann also im Transistor 2T kein die Messung des Transistor 1T störender Strom fließen. Mit der Erfindung kann also die korrekte Beschaltung der Pins 1, 2 und 4 der Schaltung IC1 mit einem Transistortester überprüft werden, ohne daß parallele Schaltungen, beispielsweise der parasitäre Transistor 2T der Schaltung IC2, einen störenden Einfluß haben.

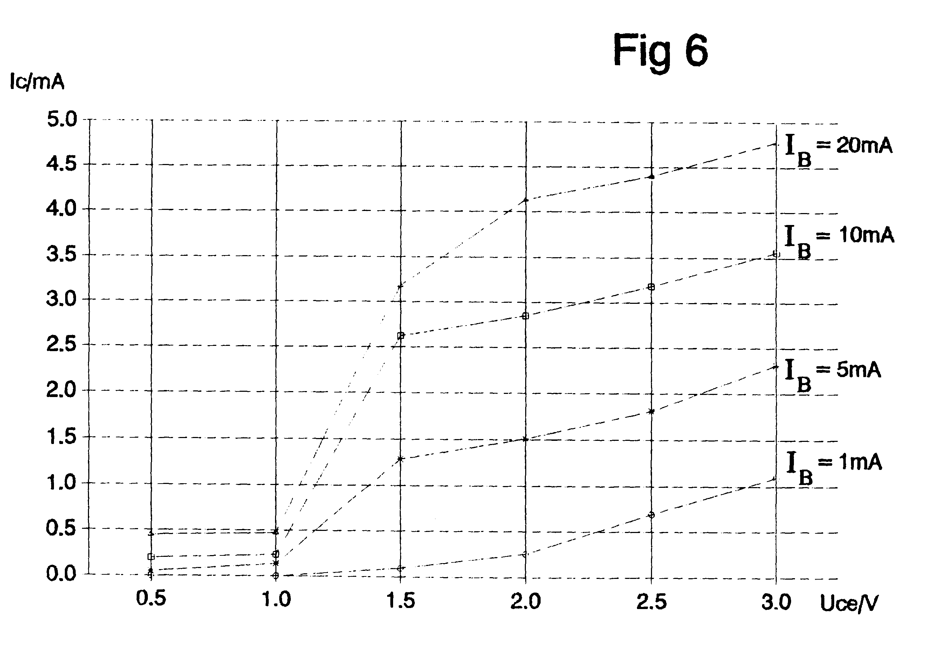

Fig. 6 zeigt ein typisches Transistorkennlinienfeld, wie es mit dem gemäß Fig. 5 angeschlossenen Transistortester ermittelbar ist. Es sind aufgetragen die Kollektorströme Ic (in mA) gegen die Kollektoremitterspannung Uce (in V). Als Parameter der dargestellten Kurven ist der Basisstrom I_{B} in mA angegeben. Anhand dieser Kurven läßt sich eine eindeutige Aussage über die ordnungsgemäße Funktion eines Transistors treffen.

Das Vorliegen eines Transistors zwischen drei kontaktierten Pins läßt sich aber auch anders als durch die Bestimmung von Transistorkennlinien erkennen. Es können beliebige Steuer- oder Schalteigenschaften bestimmt werden, die für einen Transistor typisch sind. Dazu kann der Transistor unter anderem auch in unterschiedlicher Beschaltung gemessen werden, also in Emitterschaltung, Basisschaltung oder Kollektorschaltung.

In Fig. 5 ist dargestellt, daß der Transistortester den parasitären Transistor 1T des IC1 ausmißt, wobei der teilweise parallelliegende parasitäre Transistor 2T des IC2 nicht stört. Soll nun der IC2 getestet werden, so wird der Transistortester an den IC2 genauso angeschlossen, wie er gemäß Fig. 5 an den IC1 angeschlossen ist. Dann liegt an 2T Kollektor-Emitterspannung U2 und Emitter-Basisspannung U1. An dem teilweise parallelliegenden parasitären Transistor 1T liegt aber wiederum die Kollektor-Basisspannung mit falscher Polarität, und es ist der Emitter offen, so daß in dem Transistor 1T kein störender Strom fließen kann. Es wird also auch hier der Transistor 2T völlig isoliert gemessen.

Durch Messen des parasitären Transistors 1T lassen sich die Pins 1, 2 und 4 des integrierten Schaltkreises überprüfen, nicht aber der Pin 3 für die Versorgungsspannung. Um auch diesen zu überprüfen, wäre der Transistortester an die Pins 4, 1 und 3 anzuschließen, wobei 1 wiederum die Basis wäre und 3 und 4 der Kollektor und der Emitter. Dann würden, wie bereits anhand der Fig. 4 erläutert, die Dioden SD und D3 einen parasitären Transistor bilden, wobei die Widerstände R3 und R4 zwar die Stromwerte beeinflussen, die charakteristische Eigenschaften des Transistorkennlinienfeldes der Fig. 6 aber unverändert lassen.

Auf die erfindungsgemäße Weise lassen sich auf Platinen eingelötete integrierte Schaltungen auch dann überprüfen, wenn sie mit bestimmten Eingängen in großer Zahl parallel liegen, beispielsweise mehrere ICs mit Eingängen an einer Busleitung. Dabei lassen sich, wie anhand der Fig. 5 erläutert, parasitäre Transistoren in einzelnen ICs einzeln und isoliert voneinander bestimmen, obwohl sie auf der Platine teilweise parallel liegen.

## Patentansprüche

1. Verfahren zum Testen von auf Platinen eingelöteten integrierten Halbleiterschaltkreisen durch Bestimmen von zwischen Pins eines integrierten Halbleiterschaltkreises bei angelegter Spannung fließenden Strömen, dadurch gekennzeichnet, daß die typischen Steuer- oder Schaltmerkmale eines parasitären Transistors (1T, 2T) des integrierten Halbleiterschaltkreises (IC1, IC2) mit einem auf der Platine mit den zu dem parasitären Transistor führenden Pins (4, 1, 2) des integrierten Halbleiterschaltkreises kontaktierten Transistortester (U2, A) bestimmt werden.

2. Verfahren nach Anspruch 1, dadurch gekennzeichnet, daß vor dem Testvorgang die verwendbaren parasitären Transistoren eines nicht eingelöteten intakten integrierten Halbleiterschaltkreises durch Bestimmung der Diodenkennlinien zwischen Kombinationen von je zwei Pins bestimmt werden.

3. Verwendung eines handelsüblichen Transistortesters zur Durchführung des Verfahrens nach Anspruch 1.

## Claims

1. Method of testing integrated semiconductor circuits soldered onto circuit boards by determining currents flowing between pins of an integrated semiconductor circuit, when a voltage is applied, characterised in that the typical control or switching characteristics of a parasitic transistor (1T, 2T) of the integrated semiconductor circuit (IC1, IC2) are determined with a transistor tester (U2, A) in contact on the circuit board with the pins (4, 1, 2) of the integrated semiconductor circuit leading to the parasitic transistor.

2. Method as claimed in Claim 1, characterised in that, prior to the testing process, the usable parasitic transistors of an intact integrated semiconductor circuit, which is not soldered on, are determined by determining the diode characteristics between combinations of two pins in each case.

3. Use of a commercially available transistor tester for carrying out the method of Claim 1.

## Revendications

1. Méthode pour tester des circuits intégrés semi-conducteurs soudes sur platines par détermination des courants circulant entre les broches d'un circuit intégré semi-conducteur lorsqu'une tension y est appliquée, **caractérisée en ce que** les caractéristiques typiques de commande et de commutation d'un transistor parasitaire (1T, 2T) du circuit intégré semi-conducteur (IC1, IC2) sont déterminées au moyen d'un testeur de transistors branché sur les broches (4, 1, 2) de la platine qui conduisent au transistor parasitaire du circuit intégré semi-conducteur.

2. Méthode selon la revendication 1, **caractérisée en ce qu'**avant de procéder au test, les transistors parasitaires utilisables d'un circuit intégré semi-conducteur intact et non soudé sur platine sont déterminés par détermination des courbes caractéristiques des diodes entre les paires des broches combinées deux par deux.

3. Utilisation d'un testeur de transistors usuel pour l'application de la méthode selon la revendication 1.
